# EUROPEAN PATENT APPLICATION

(11) **EP 2 164 102 A1**
(43) Date of publication of application: **17.03.2010**
(21) Application number: 08752933.5
(22) Date of filing: 19.05.2008
(51) Int. Cl.: H01L 27/14, G01T 1/24, G01T 7/00, H04N 5/32

(54) **RADIOACTIVE RAY DETECTOR**

(30) Priority: 05.06.2007 JP 2007149364
(71) Applicant: Fujifilm Corporation, Tokyo 106-8620 (JP)
(72) Inventor: OKADA, Yoshihiro, Ashigarakami-gun Kanagawa 258-0023 (JP)
(74) Representative: Klunker . Schmitt-Nilson . Hirsch
(86) International application number: PCT/JP2008/059113
(87) International publication number: WO 2008/149655

(57) **Abstract**

Intended is to suppress the separation by a thermal stress between an upper substrate and a lower substrate jointed through a joint member, and to suppress a creeping discharge from an upper electrode to a lower electrode. An active matrix substrate and a glass substrate are jointed at their outer peripheral portions so that the joint area, in which the active matrix substrate and the glass substrate are jointed, can be reduced. This makes it possible to reduce the thermal stress to be caused between the active matrix substrate and the glass substrate, and to suppress the separation between the active matrix substrate and the glass substrate jointed with an adhesive resin. Moreover, a semiconductor layer is covered at its peripheral end portion with the adhesive resin, so that a creeping discharge, as might otherwise occur from a bias electrode to a charge collecting electrode, can be suppressed through a clearance even if the clearance is created between the peripheral end portion of the semiconductor layer and the active matrix substrate.

## Description

### Technical Field

The present invention relates to a radiation detector employed in a medical X-ray imaging apparatus or the like.

### Related Art

As radiation detectors, FPD's (Flat Panel Detectors) and the like that have a semiconductor layer disposed on an active matrix substrate and can directly convert radiation data into digital data, have been put into practice. These FPD's are advantageous, in comparison to previous imaging plates, in that images can be checked instantly and video images can also be checked, and use of such FPD's is rapidly spreading.

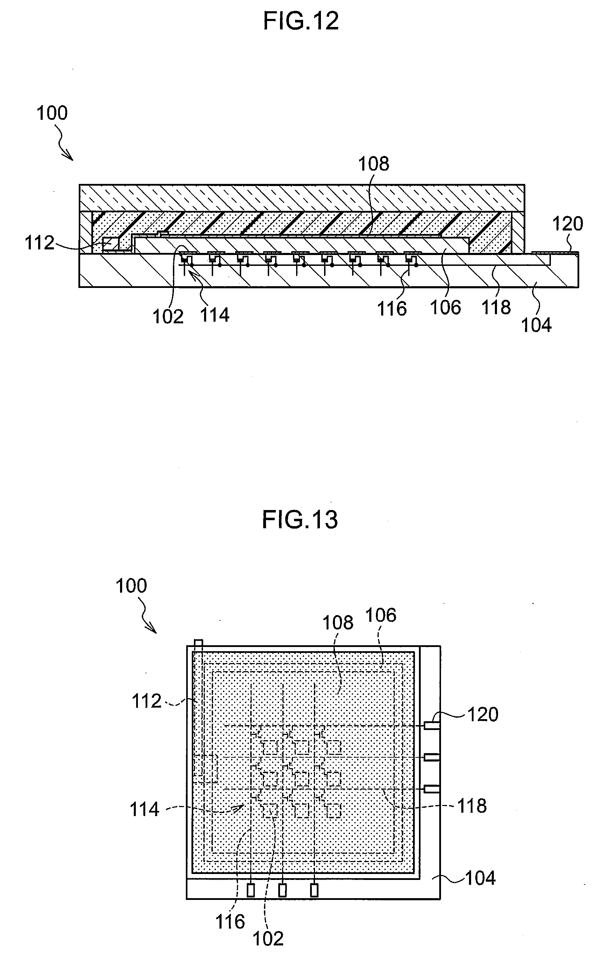

Explanation will now be given of a configuration of a conventional FPD, with reference to Fig. 12 and Fig. 13.

A conventional FPD 100, as shown in Fig. 12 and Fig. 13, includes charge collecting electrodes 102 disposed in an array as lower electrodes on an active matrix substrate (lower substrate) 104.

A semiconductor layer (charge conversion layer) 106 having electromagnetic conduction is formed on the active matrix substrate 104, and an upper electrode 108 is formed next in sequence thereon. The upper electrode 108 is connected to a high voltage power source (not shown in the drawings) through a conductor 112.

The semiconductor layer 106 has selenium as the main component thereof, as an amorphous a-Se film of 100 to 1000 µm film thickness. Charge is generated within the film on irradiation with X-rays.

TFT switches 114 and charge storage capacitors (not shown in the drawings) are connected to the charge collecting electrodes 102 disposed in an array on the active matrix substrate 104. The drain electrodes of the TFT switches 114 are connected to one of the electrodes of the charge storage capacitors.

The other electrode of the charge storage capacitors is connected to storage capacitance lines. Scan lines 116 are connected to gate electrodes of the TFT switches 114, data lines 118 are connected to the source electrodes thereof, and a signal detector (amplifier or the like) (not shown in the drawings) is connected through terminals 120 to the ends of the data lines 118 (see, for example, Japanese Patent Application Laid-Open (JP-A) No. 2001-148475 and JP-ANo. 2001-111019).

The photoelectric conversion material employed in the FPD 100, such as selenium or the like, readily deteriorates due to changes in the environment, such as heat, temperature, contamination or the like. Sufficient withstand voltage counter measures are also required since a high voltage of 1kV to 10kV is applied to the upper electrode 108. Creeping discharge, from the upper electrode to the lower electrodes, must also be prevented.

Therefore, a configuration in which a semiconductor film and an upper electrode are tightly sealed (molded) is employed, using the configuration described in JP-A No. 2001-148475.

### Disclosure of the Invention

### Problem to be Solved by the Invention

Generally radiation detectors for so-called general imaging are used in chest imaging devices. In such cases, the size of the detector apparatus exceeds 17 inches × 17 inches.

Great internal stress is generated by temperature changes when an upper substrate and a lower substrate formed from glass are joined with a resin adhesive as a joint member. The upper substrate and the lower substrate may separate or break due to this internal stress. This is caused by differences between the linear expansion coefficients of the resin adhesive and glass, and such a difference in linear expansion cannot be physically eliminated.

The resin adhesive must also have sufficient adhesive force, and must have characteristics to prevent creeping discharge from the upper electrode to the lower electrode. Therefore the scope for material selection is limited, and it is also difficult to reduce the linear expansion difference.

The present invention is made in consideration of the above circumstances and provides a radiation detector that can suppress separation due to thermal stress of an upper electrode and a lower electrode joined with a joint member, and can suppress creeping discharge from the upper electrode to the lower electrode.

### Method of Solving the Problem

According to a first aspect of the present invention, a radiation detector includes: a charge conversion layer that generates charge by irradiation with radiation when in bias voltage-applied state; a lower substrate, provided beneath the charge conversion layer and having a lower electrode that collects the charge generated in the charge conversion layer; an upper electrode, formed as a layer above the charge conversion layer, for applying the bias voltage to the charge conversion layer; an upper substrate, provided above the upper electrode and covering the upper electrode; and a joint member, provided above an outer peripheral portion of the lower substrate, covering only an outer peripheral portion of the charge conversion layer, and joining the outer peripheral portion of the lower substrate to an outer peripheral portion of the upper substrate.

According to this aspect, the bias voltage is applied to the charge conversion layer via the upper electrode. The charge conversion layer generates charge by irradiation with radiation when in bias voltage-applied state. The charge generated in the charge conversion layer is collected by the lower electrode.

In the first aspect of the present invention here, since the lower substrate and the upper substrate are joined to each other at outer peripheral portions thereof, the joined surface area joining the lower substrate and the upper substrate can be reduced in comparison to a configuration where the lower substrate and the upper substrate are joined over their entire surfaces. By reducing the joined surface area, any thermal stress occurring between the lower substrate or the upper substrate, and the joint member, can be made small, and separation of the lower substrate and the upper substrate joined by the joint member can be suppressed.

In addition, since the peripheral edge portion of the charge conversion layer is covered by the joint member, even if a gap develops between the peripheral edge portion of the charge conversion layer and the lower substrate, occurrences of creeping discharge from the upper electrode to the lower electrode through such a gap can be suppressed.

According to another aspect of the present invention, in a radiation detector of the first aspect, the joint member covers at least a portion of the peripheral edge portion of the upper electrode.

According to the above aspect, since the joint member covers at least a portion of the peripheral edge portion of the upper electrode, creeping discharge from the peripheral edge portion of the upper electrode to the lower electrode can be suppressed.

According to yet another aspect of the present invention, in a radiation detector of the above aspect, an insulating film is formed above the upper electrode and covering the upper electrode.

According to this aspect, since the insulating film is formed covering the upper electrode, creeping discharge from the upper electrode to the lower electrode can be suppressed.

### Effect of the Invention

The present invention, according to the above aspects, can suppress separation due to thermal stress of an upper electrode and a lower electrode joined with a joint member, and can suppress creeping discharge from the upper electrode to the lower electrode.

### Brief Description of the Drawings

Fig. 1 is a cross-sectional view of a radiation detector according to the present exemplary embodiment.
Fig. 2 is a plan view of the radiation detector of Fig. 1, shown in a state with the glass substrate removed.
Fig. 3A is a figure showing an example of a manufacturing process of the radiation detector according to the present exemplary embodiment.
Fig. 3B is a figure showing an example of a manufacturing process of the radiation detector according to the present exemplary embodiment.
Fig. 3C is a figure showing an example of a manufacturing process of the radiation detector according to the present exemplary embodiment.
Fig. 3D is a figure showing an example of a manufacturing process of the radiation detector according to the present exemplary embodiment.
Fig. 3E is a figure showing an example of a manufacturing process of the radiation detector according to the present exemplary embodiment.
Fig. 3F is a figure showing an example of a manufacturing process of the radiation detector according to the present exemplary embodiment.
Fig. 3G is a figure showing an example of a manufacturing process of the radiation detector according to the present exemplary embodiment.
Fig. 4 is a cross-sectional view showing a configuration without a rib member in the radiation detector according to the present exemplary embodiment.
Fig. 5 is a plan view of the radiation detector of Fig. 4, shown in a state with the glass substrate removed.
Fig. 6 is a cross-sectional view showing a configuration formed with an insulating film in a radiation detector according to the present exemplary embodiment.
Fig. 7 is a plan view of the radiation detector of Fig. 6, shown in a state with the glass substrate removed.
Fig. 8 is a cross-sectional view of the radiation detector of Fig. 6, showing a configuration in which the insulating film extends onto the active matrix substrate.
Fig. 9 is a plan view of the radiation detector of Fig. 8, shown in a state with the glass substrate removed.
Fig. 10 is a cross-sectional view of a combination of a configuration without a rib member in the radiation detector according to the present exemplary embodiment, and a configuration formed with an insulating film.
Fig. 11 is a plan view of the radiation detector of Fig. 10, shown in a state with the glass substrate removed.
Fig. 12 is a cross-sectional view of a conventional radiation detector.
Fig. 13 is a plan view of the radiation detector of Fig. 12, shown in a state with the glass substrate removed.

### Best Mode of Implementing the Invention

Explanation will be given below of an exemplary embodiment of the present invention, with reference to the drawings.

### (Configuration of Radiation detector According to the Present Exemplary Embodiment)

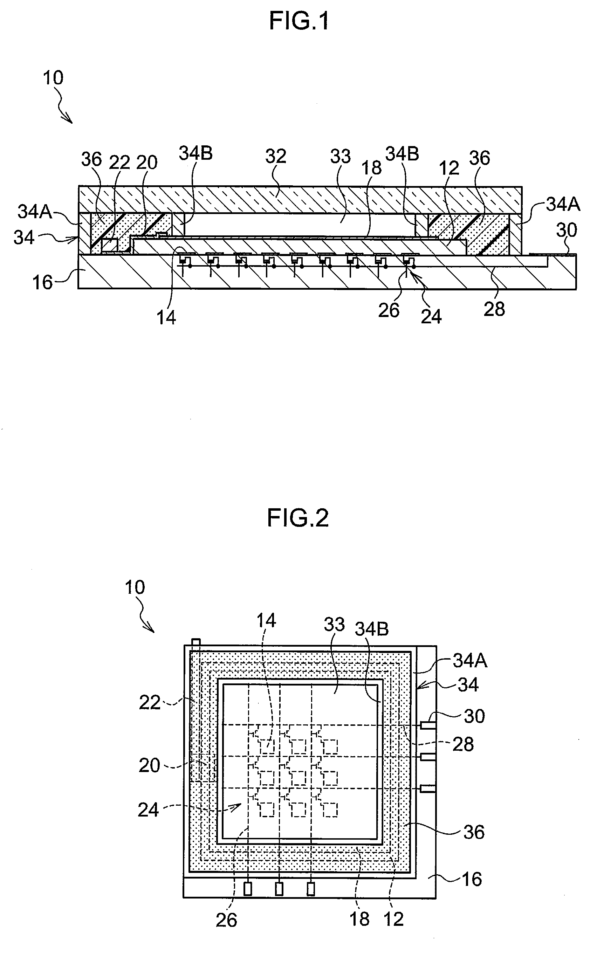

Explanation will first be given of a configuration of a radiation detector according to the present exemplary embodiment. Fig. 1 is a cross-sectional view of a radiation detector according to the present exemplary embodiment. Fig. 2 is a plan view of the radiation detector of Fig. 1, shown in a state with the glass substrate 32 removed.

The radiation detector 10 according to the present exemplary embodiment, as shown in Fig. 1 and Fig. 2, is provided with a semiconductor layer 12 having electromagnetic conductive properties, serving as a charge conversion layer that generates charge by irradiation with radiation when in a state applied with a bias voltage. The semiconductor layer 12 is, for example, formed from an amorphous a-Se film of 100 to 1000 µm film thickness, having selenium as the main component thereof. Note that other photoelectric conversion materials may be employed for the semiconductor layer 12.

An active matrix substrate 16 is provided as a lower electrode beneath the semiconductor layer 12. The active matrix substrate 16 has, as lower electrodes, charge collection electrodes 14 that collect charge generated in the semiconductor layer 12. The charge collection electrodes 14 are, as shown in Fig. 2, disposed in an array on the active matrix substrate 16.

The semiconductor layer 12 is formed as a layer on the active matrix substrate 16. A bias electrode 18 is, as an upper electrode, formed as a layer onto this semiconductor layer 12, for applying a bias voltage to the semiconductor layer 12. The bias electrode 18 is, for example, formed from Au.

The bias electrode 18 is connected to an extraction terminal 22 via electro-conductive tape 20. In addition, the bias electrode 18 is electrically connected to a high voltage power supply (not shown in the drawings) through this extraction terminal 22. A high voltage of, for example, 1kV to 10kV is applied from the high voltage power supply to the bias electrode 18.

When radiation, such as X-rays or the like, is irradiated onto the semiconductor layer 12 in a state in which a bias voltage is applied thereto by the high voltage power supply via the bias electrode 18, charge is generated internally within the semiconductor layer 12.

TFT switches 24 and charge storage capacitors (not shown in the drawings) are connected to the charge collection electrode 14 disposed in an array on the active matrix substrate 16. The drain electrodes of the TFT switches 24 and one of the electrodes of the charge storage capacitors are connected to each other. The other electrode of the charge storage capacitors is connected to storage capacitor lines.

Scan lines 26 are connected to the gate electrodes of the TFT switches 24, data lines 28 are connected to the source electrodes of the TFT switches 24, and a signal detector (amplifier or the like) (not shown in the drawings) is connected to the ends of the data lines 28 through terminals 30.

Since the photoelectric conversion material employed in the semiconductor layer 12, such as selenium or the like, readily deteriorates due to changes in the environment, such as heat, temperature, contamination or the like, some sort of cover is required. In addition, it is also necessary to secure sufficient withstand voltage since the bias electrode 18 is applied with a high voltage of 1kV to 10kV.

In order to address this, in the present exemplary embodiment, the glass substrate 32 is provided as an upper substrate on the bias electrode 18 at an upper portion of the device, covering over the bias electrode 18.

The glass substrate 32 is preferably of the same substance and same thickness as the active matrix substrate 16, and in the present exemplary embodiment a non-alkali glass of 0.7mm thickness is employed. Rib members 34 are provided between the active matrix substrate 16 and the glass substrate 32, standing up from the active matrix substrate 16 and supporting the glass substrate 32. The rib members 34 are, for example, formed from a resin material, such as an acrylic resin or the like.

The rib members 34 are configured with rib members 34A disposed above an outer peripheral portion of the active matrix substrate 16, and rib members 34B disposed above an outer peripheral portion of the-bias electrode 18.

The rib members 34A are formed in a rectangular shape when seen in plan view, and configure four side walls at the four sides. The four side walls stand up above the outer peripheral portion of the active matrix substrate 16 and surround the perimeter of the semiconductor layer 12.

The rib members 34B are formed in a rectangular shape when seen in plan view, and configure four side walls at the four sides. A space 33 of a specific size is formed in a rectangular shape in plan view, enclosed at the inside of these four side walls. The space 33 is a region of about 70% or more of the active area disposed with the charge collection electrodes 14, is preferably the whole region of the active area, and the bias electrode 18 and the glass substrate 32 are not in close contact with each other. Due to the above configuration, absorption of radiation by the resin material is avoided, and a high detection efficiency as a radiation detector can be realized.

An adhesive resin 36 is filled in a region between the side walls of the rib members 34B and the side walls of the rib members 34A (a grey portion in the drawings), as a joint member joining the outer peripheral portion of the active matrix substrate 16 to the outer peripheral portion of the glass substrate 32. The active matrix substrate 16 and the glass substrate 32 are fixed, by the adhesive resin 36 joining the outer peripheral portion of the active matrix substrate 16 and the outer peripheral portion of the glass substrate 32. For example, a resin, such as epoxy or the like, is used for the adhesive resin 36.

The region between the side walls of the rib members 34B and the side walls of the rib members 34A is above the outer peripheral portion of the active matrix substrate 16. A peripheral portion of the semiconductor layer 12, a peripheral portion of the bias electrode 18, the electro-conductive tape 20 and the extraction terminal 22 are disposed in this region. The peripheral portion of the semiconductor layer 12, the peripheral portion of the bias electrode 18, the electro-conductive tape 20 and the extraction terminal 22 are covered by the adhesive resin 36 due to the adhesive resin 36 being filled into this region.

Note that the adhesive resin 36 does not need to cover the entire periphery of the peripheral portion of the bias electrode 18, and a portion of the peripheral portion of the bias electrode 18 may be covered. In a similar manner, when the peripheral portion of the semiconductor layer 12 is covered, the entire periphery of the peripheral portion of the semiconductor layer 12 does not need to be covered, and a portion of the peripheral portion of the semiconductor layer 12 may be covered. In addition, configuration may also be made in which the adhesive resin 36 does not cover the peripheral portion of the bias electrode 18, and only covers the peripheral portion of the semiconductor layer 12.

### (Operation of the Present Exemplary Embodiment)

Explanation will now be given of the operation of the above exemplary embodiment.

When radiation, such as X-rays or the like, is irradiated onto the semiconductor layer 12 in a state in which a bias voltage is applied to the semiconductor layer 12 through the bias electrode 18, charge is generated internally within the semiconductor layer 12. The charge generated internally within the semiconductor layer 12 migrates to the charge collection electrode 14, and as a result charge is stored in the charge storage capacitors.

The charge that has been stored in the charge storage capacitors is externally extractable through the source electrode of the TFT switches 24, by the TFT switches 24 being placed in an ON-state by an input signal to the gate electrode of the TFT switches 24. The electrode lines formed by the gate electrodes and the source electrodes, the TFT switches 24 and the charge storage capacitors are all provided in a matrix. Therefore, two-dimensional image data of the radiation is obtainable by successively scanning a signal input to the gate electrodes, and detecting a signal from the source electrodes for each of the source electrodes.

In the present exemplary embodiment, the active matrix substrate 16 and the glass substrate 32 are joined together by outer peripheral portions thereof. Therefore, the joined surface area joining the active matrix substrate 16 and the glass substrate 32 can be reduced.

When, as in the conventional technique, the glass substrate and the active matrix substrate are fixed over nearly their entire faces by an adhesive resin or the like, a high thermal stress is generated between the adhesive resin and the active matrix substrate, or the glass substrate, due to temperature changes. Due to this high thermal stress, separation of the substrates occurs with only a slight temperature change, such as at, for example, around -10 °C or less, or 50 °C or above. When employed in a hospital or the like, while maintained at around 20 °C to 30 °C by air conditioning, environments of -10 °C and 50 °C can well be contemplated when power is interrupted or when dispatched outside, and so even for a medical device, the ability to withstand temperatures such as those above is sought.

However, in the present exemplary embodiment, since the joined surface area joining the adhesive resin 36 with the active matrix substrate 16 and with the glass substrate 32 is small, any thermal stress occurring between the active matrix substrate 16, or the glass substrate 32, and the adhesive resin 36 can be suppressed. For example, if about 70% of the glass substrate 32 is fixed, the thermal stress is reduced to about 30% of the thermal stress that occurs when the entire surface is fixed. Consequently, separation of the active matrix substrate 16 and the glass substrate 32, joined together by the adhesive resin 36, can be suppressed, and the ability to withstand changes in the environment of the radiation detector 10 can be raised.

In addition, since the peripheral portion of the semiconductor layer 12 is covered by the adhesive resin 36, even if a gap develops between the peripheral portion of the semiconductor layer 12 and the active matrix substrate 16, occurrences of creeping discharge from the bias electrode 18 to the charge collection electrode 14 through such a gap can be suppressed.

Electric field concentration readily occurs at the end face of the peripheral portion of the bias electrode 18, and discharge from the bias electrode 18 readily occurs when a high voltage of several hundred to several thousand volts is applied to the bias electrode 18. External discharge does not occur due to the glass substrate 32 being present above the bias electrode 18, but discharge damage to the charge collection electrode 14 and the wiring pattern on the active matrix substrate 16, and electrical noise to the data lines 28, is triggered (creeping discharge).

Against such occurrences, the adhesive resin 36 covers the bias electrode 18, the electro-conductive tape 20 and the extraction terminal 22, and so creeping discharge, from the peripheral portion of the bias electrode 18 to the charge collection electrodes 14, the wiring pattern and the data lines 28, can be suppressed.

In addition, since in order to prevent creeping discharge it is sufficient to cover the peripheral portion of the bias electrode 18, the electro-conductive tape 20 and the extraction terminal 22 with the adhesive resin 36 formed from an insulating material, such as epoxy or the like, as in the present exemplary embodiment, creeping discharge can be suppressed even though epoxy resin is not disposed at the central portion of the bias electrode 18.

Note that while the present exemplary embodiment is of a configuration in which the space 33 is not filled with a filling material, a material with a Young's modulus lower than that of the adhesive resin 36 and the rib members 34, such as a gas, liquid, rubber or soft resin, may be used to fill the space 33. Even when of such a configuration, a reduction in the thermal stress generated to the active matrix substrate 16 and the glass substrate 32 is achieved.

When the same material is used for the adhesive resin 36 and the rib members 34, even when a material having a Young's modulus the same as, or greater than, that of the adhesive resin 36 and the rib members 34 is used, configuration may be made that reduces the thermal stress generated to the active matrix substrate 16 and the glass substrate 32 by only joining this material to one or other of the glass substrate 32 or the active matrix substrate 16, and providing a free state by forming a gap without bonding to the other.

In addition, in order to positively prevent contact with the inner peripheral side of the rib members 34B due to bowing of the glass substrate 32, a spacer may be disposed between the glass substrate 32 and the bias electrode 18. In such cases, the space 33 may be formed at point locations at the inner peripheral side of the rib members 34B.

### (Manufacturing Processes for the Radiation detector)

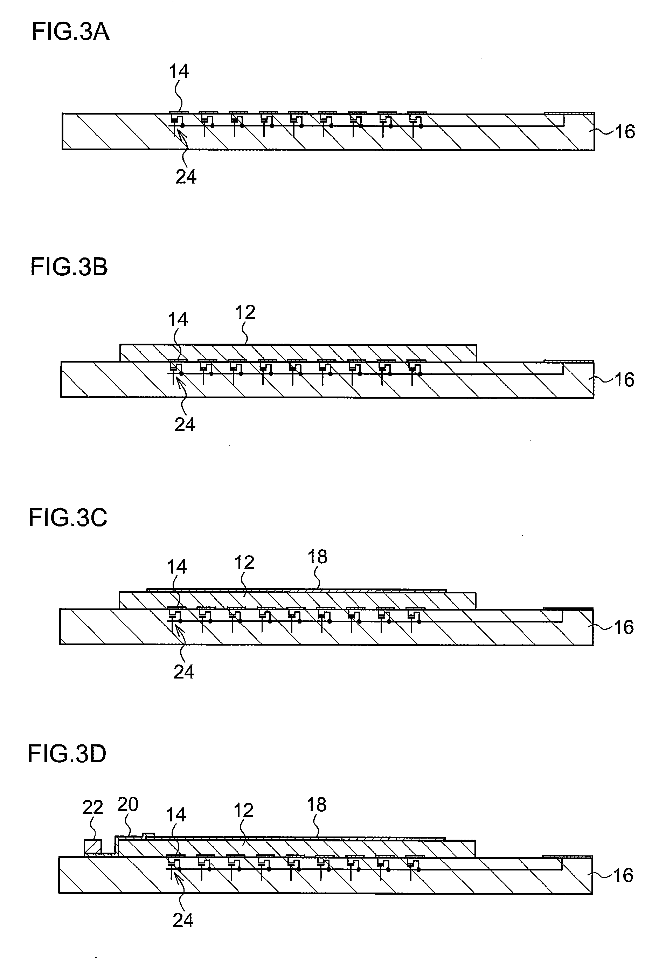

Explanation will now be given of an example of manufacturing processes of the radiation detector 10 configured as described above, with reference to Fig. 3A to Fig. 3G.

First, as shown in Fig. 3A and Fig. 3B, a semiconductor layer 12 formed from selenium is deposited by vacuum deposition onto the active matrix substrate 16 arrayed with the charge collection electrodes 14, the TFT switches 24 and the charge storage capacitors. The film thickness of the selenium is about 0.1mm to 1mm, with the radiation detection sensitivity increasing with thickness.

A compound material having selenium as a main component thereof may be used for the semiconductor layer 12, and a film for improving the photoelectric conversion ability may be formed on the top and/or bottom face of the semiconductor layer 12.

Next, as shown in Fig. 3C, the bias electrode 18, formed from an Au thin film, is formed by vacuum deposition onto the semiconductor layer 12. The film thickness of the Au film is about 50nm to 100nm. A deposit mask is employed during Au deposition, such that the Au is deposited up to about 1mm to 10mm to the inside of the semiconductor layer 12. This is done because when the bias electrode 18 is made larger than the semiconductor layer 12 and disposed above the active matrix substrate 16, discharge damage and creeping discharge is generated from this portion.

Next, as shown in Fig. 3D, the extraction terminal 22 is connected to the bias electrode 18. When doing so, a pad on the active matrix substrate 16 is connected to the bias electrode 18 by means of the electro-conductive tape 20, and the extraction terminal 22 is fixed to the pad on the active matrix substrate 16 by an adhesive.

Note that during vacuum deposition of the Au film, the Au film may be extended out up to the extraction terminal 22 of the active matrix substrate 16, forming the electrode extraction portions. In such cases, in order to prevent discharge damage and creeping discharge, preferably the data lines 28 are not disposed in adjacent to the electrode extraction portion, and complete coverage is made by the adhesive resin 36, including coverage of the electrode extraction portions and the extraction terminal 22.

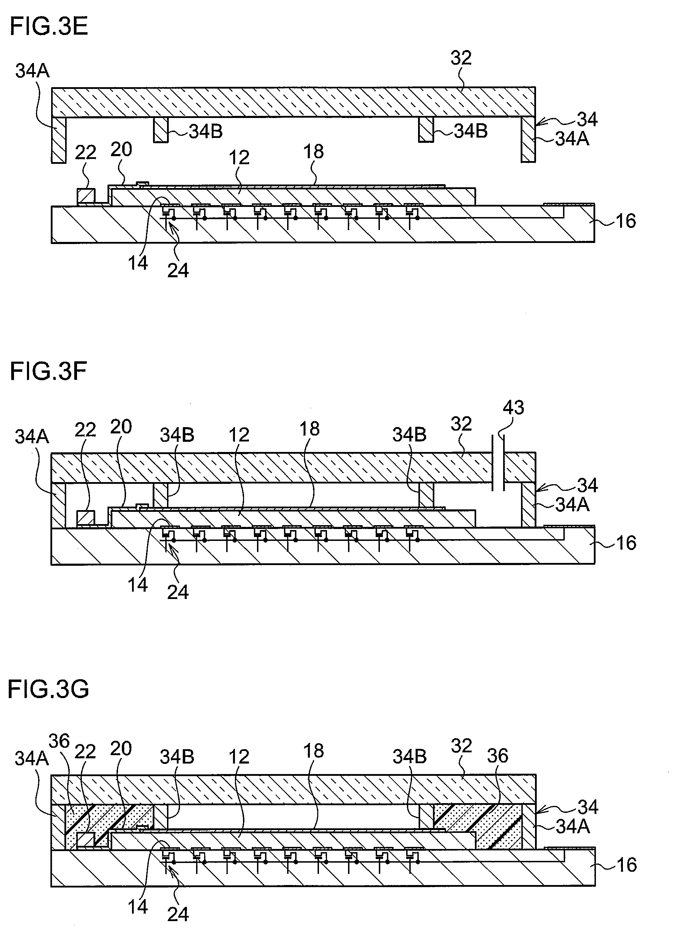

Next, as shown in Fig. 3E and Fig. 3F, an upper protection member, formed from the glass substrate 32 and the rib members 34, is attached onto the active matrix substrate 16. The upper protection member is configured with the glass substrate 32 and two rib members fixed together with adhesive, and bonded onto the active matrix substrate 16 with an adhesive member.

From the two type of rib members 34, the rib members 34B are disposed to the inside of the bias electrode 18 formed from Au, and are designed such that the peripheral portion of the bias electrode 18 does not come inside of the rib members 34B.

The width of the rib members 34B is about 2mm to 10mm, and an insulating material is employed therefor in order to prevent creeping discharge. A seal member, as used for attaching a liquid crystal display or the like, may be employed for the inside rib members 34B. The outside rib members 34A are members that form the outer profile of the device, and are disposed sufficiently, about 3mm to 20mm, to the outside of the semiconductor layer 12.
The outside rib members 34A are also about 2mm to 10mm in width. The height of the outside rib members 34A is 0.5mm to 10mm, and the inside rib members 34B employs a material having of thickness minus the thickness of the semiconductor layer 12 and the thickness of the bias electrode 18 (0.1mm to 1mm).

Since there is a chance of contact with the bias electrode 18 due to bowing of the glass substrate 32, preferably sufficient clearance is secured between the glass substrate 32 and the bias electrode 18, for example 5mm or greater. This is because the glass substrate 32 can bow by 2mm to 3mm under its own weight and/or external pressure.

Spacers may also be disposed between the glass substrate 32 and the bias electrode 18 in order to positively prevent contact due to bowing of the glass substrate 32. Such spacers can be realized by disposing resin spacers of 5 µm to 20 µm on the glass substrate 32, by filling with a resin insulating material, such as a silicone resin or the like, that does not harden at room temperature, by coating the glass substrate 32 with an epoxy resin and, by curing, fixing only to the glass substrate 32, or by another such method.

Next, as shown in Fig. 3F and Fig. 3G, the adhesive resin 36 is injected though an injection hole 43 provided in a portion of the upper protection member. In the present exemplary embodiment, an epoxy material that cures at room temperature is employed for the adhesive resin 36.

In Fig. 3F, the injection hole 43 is opened in the glass substrate 32, at an upper portion of the upper protection member, however it is easy, from a manufacturing perspective, to provide the injection hole 43 in the rib members 34 that are formed from an acrylic resin. After injection, the injection hole is sealed, and after leaving for about 24 hours at room temperature, the epoxy material is cured, and the radiation detector 10 is completed.

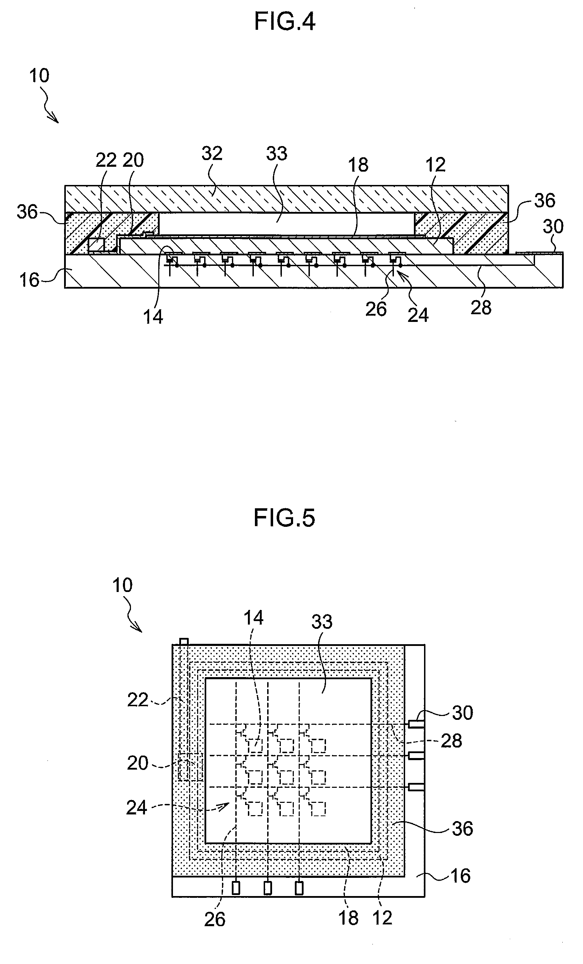

It should be noted that the thickness of the semiconductor layer 12 has a variation of about 20% at the inside face, and consequently optimization of the inside rib members 34B often cannot be made due to this. In order to address this, as shown in Fig. 4 and Fig. 5, a thick adhesive resin 36 (seal member) alone may be employed in place of the rib members 34. The adhesive resin 36 (seal member) is coated onto the active matrix substrate 16 in an image forming apparatus, and then the glass substrate 32 is attached and the adhesive resin 36 (seal member) is cured by leaving at room temperature.

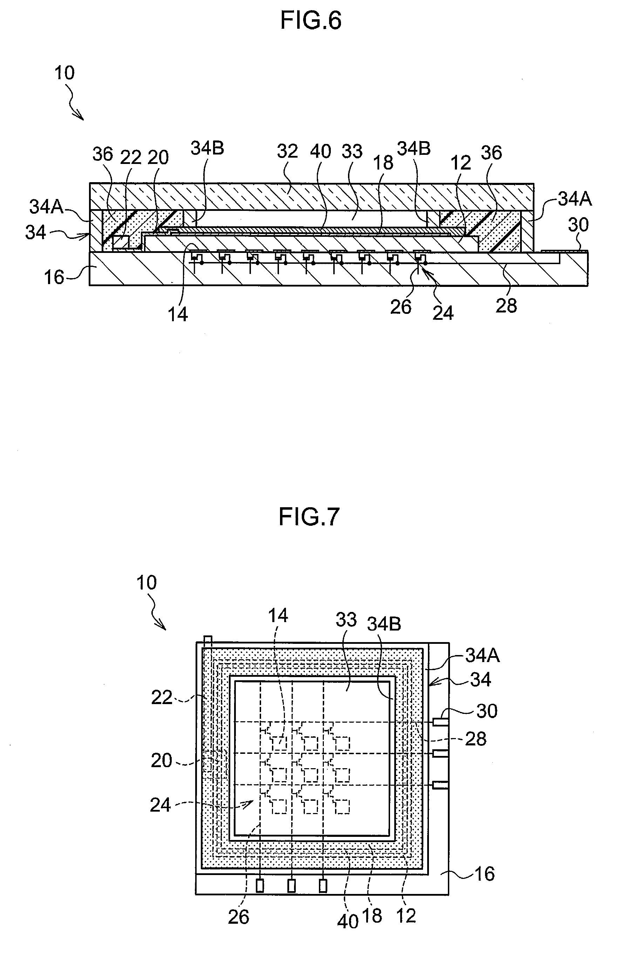

In addition, as shown in Fig. 6, Fig. 7, Fig. 8 and Fig. 9, the radiation detector 10 may be configured with a parylene film 40 formed on the bias electrode 18 as an insulating film covering the bias electrode 18.

Parylene is formed using a vacuum deposition method at a film thickness of about 0.1 to 3 µm. As well as the parylene film another insulating film formed by a CVD method may be employed as the insulating film, such as an SiNx film, an SiOx film or the like, or an SiNx, SiOx film deposited using a sputtering method may be employed therefor.

In this manner, creeping discharge may be even further suppressed by forming the insulating film, such as the parylene film 40 or the like, on the bias electrode 18, and insulating properties can be further raised.

The parylene film 40 forming is performed, in the processes shown in Fig. 3A to Fig. 3G, between the process of connecting the extraction terminal 22 of the bias electrode 18, and the process of attaching the upper protection member, formed from the glass substrate 32 and the rib members 34, onto the active matrix substrate 16.

In addition, the parylene film 40 is formed selectively deposited only in an area covering the bias electrode 18, using a template (deposit mask). The parylene film 40 is not deposited on the terminal portions of the TFT switches 24, since this would prevent input and output of signals.

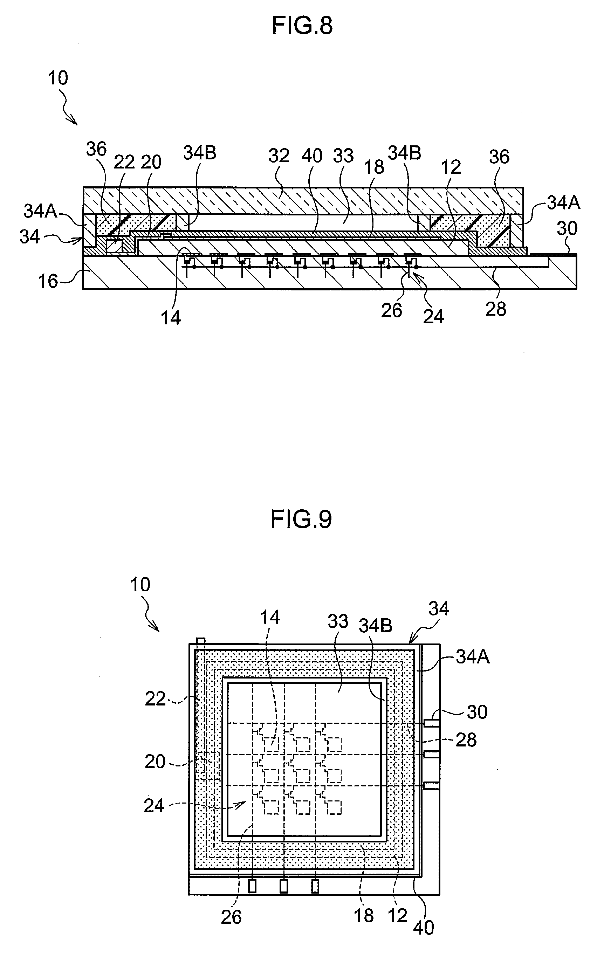

Also, in order to strengthen the insulating properties, the parylene film 40 may be extended out onto the active matrix substrate 16, as shown in Fig. 8 and Fig. 9. However, in order to achieve good sealing ability between the rib members 34A and the active matrix substrate 16 a configuration is preferable in which, as shown in Fig. 6 and Fig. 7, the parylene film 40 is formed on the semiconductor layer 12 but not deposited in regions that become the bottom layer of the outside rib members 34A.

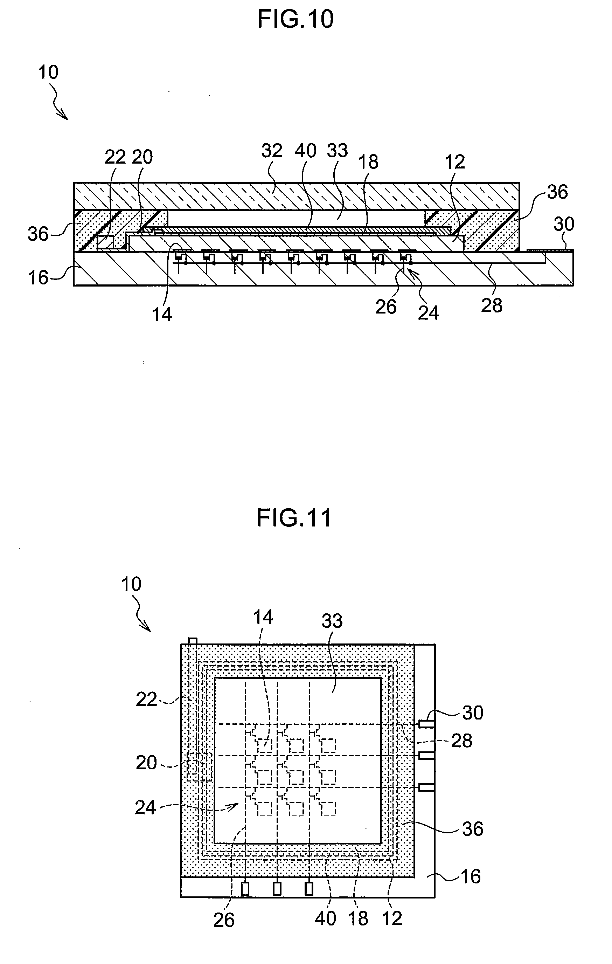

Note that, as shown in Fig. 10 and Fig. 11, a combination may be made of the configuration of Fig. 6 in which an insulating film, such as the parylene film 40 or the like, is formed, together with the configuration of Fig. 4 of the thick adhesive resin 36 (seal member) alone.

The present invention is not limited to the exemplary embodiments described above, and various variations, modifications and improvements are possible.

## Claims

1. A radiation detector comprising:
a charge conversion layer that generates charge by irradiation with radiation when in bias voltage-applied state;
a lower substrate, provided beneath the charge conversion layer and having a lower electrode that collects the charge generated in the charge conversion layer;
an upper electrode, layered above the charge conversion layer, for applying the bias voltage to the charge conversion layer;
an upper substrate, provided above the upper electrode and covering the upper electrode; and
a joint member, provided above an outer peripheral portion of the lower substrate, covering only an outer peripheral portion of the charge conversion layer, and joining the outer peripheral portion of the lower substrate to an outer peripheral portion of the upper substrate.

2. The radiation detector of claim 1, wherein the joint member covers at least one portion of the outer peripheral portion of the upper electrode.

3. The radiation detector of claim 1, comprising an insulating film formed above the upper electrode and covering the upper electrode.

4. The radiation detector of claim 2, comprising an insulating film formed above the upper electrode and covering the upper electrode.
